# EUROPÄISCHE PATENTSCHRIFT

(11) **EP 3 230 991 B1**
(45) Veröffentlichungstag und Bekanntmachung des Hinweises auf die Patenterteilung: **01.09.2021**
(21) Anmeldenummer: 15804477.6
(22) Anmeldetag: 03.12.2015
(51) Int. Cl.: H01F 17/06

(54) **FILTERANORDNUNG, SPANNUNGSWANDLER MIT EINER FILTERANORDNUNG**
FILTER ASSEMBLY, VOLTAGE CONVERTER HAVING A FILTER ASSEMBLY
DISPOSITIF DE FILTRAGE, CONVERTISSEUR DE TENSION POURVU D'UN DISPOSITIF DE FILTRAGE

(30) Priorität: 10.12.2014 DE 102014225416
(43) Veröffentlichungstag der Anmeldung: 18.10.2017
(73) Patentinhaber: Vitesco Technologies Germany GmbH, 30165 Hannover (DE)
(72) Erfinder: ADAM, Karl-Heinz, 94536 Eppenschlag (DE); BLÖSCH, Christoph, 91088 Bubenreuth (DE)
(74) Vertreter: Waldmann, Georg Alexander
(86) Internationale Anmeldenummer: PCT/EP2015/078442
(87) Internationale Veröffentlichungsnummer: WO 2016/091700

(56) Entgegenhaltungen:
- JP-A- 2003 188 033
- JP-A- 2004 047 769
- JP-A- 2011 100 807
- US-A1- 2010 176 909
- US-A1- 2014 266 558

## Beschreibung

Die vorliegende Erfindung betrifft eine Filteranordnung, insb. eine Filteranordnung zum Filtern von Ausgangsströmen eines Spannungswandlers, speziell eines DC-DC-Wandlers oder eines AC-DC-Wandlers. Ferner betrifft die Erfindung einen Spannungswandler mit einer genannten Filteranordnung.

Spannungswandler werden oft in leistungselektrischen Bereichen verwendet, insbesondere in Bordnetzen von Kraftfahrzeugen mit zwei oder mehr Bordnetzzweigen, in denen verschiedene Spannungsniveaus herrschen und in denen eine Spannung eines Spannungsniveaus in eine Spannung eines anderen Spannungsniveaus unidirektional oder bidirektional umgewandelt werden muss. Ausgangsströme dieser Spannungswandler enthalten konstruktionsbedingt Wechselspannungsanteile, die zu Funktionsstörungen bei den nachgeschalteten elektrischen oder elektronischen Komponenten führen können. Daher gibt es Funkentstör-Grenzwerte, insb. in dem Automobilbereich, für die Ausgangsströme von Spannungswandlern, die eingehalten werden müssen.

Um die Funktionsstörungen durch Ausgangsströme der Spannungswandler zu vermeiden, müssen die Ausgangsströme der Spannungswandler gefiltert werden, bevor diese zu den nachgeschalteten elektrischen oder elektronischen Komponenten weitergeleitet werden.

Hierzu werden Filteranordnungen (EMV-Filter (EMV: Elektromagnetische Verträglichkeit)) in den Spannungswandlern vorgesehen, welche die Wechselspannungsanteile in den Ausgangsströmen der Spannungswandler abschwächen bzw. filtern.

Filteranordnungen gemäß dem Oberbegriff von Anspruch 1 sind aus JP 2011 100807 A und aus US 2010 176909 A1 bekannt.

Wie bei technischen Systemen üblich, besteht auch bei den Spannungswandlern die allgemeine Anforderung, diese bei einer gleichbleibenden oder besseren Funktionalität kompakter und bauraumsparender zu bauen.

Damit besteht die Aufgabe der vorliegenden Erfindung darin, eine Filteranordnung bei einer gleichbleibenden bzw. besseren Filterwirkung bauraumsparender zu bauen.

Diese Aufgabe wird durch Gegenstände der unabhängigen Ansprüche gelöst. Vorteilhafte Ausgestaltungen sind Gegenstand der Unteransprüche.

Gemäß einem ersten Aspekt der Erfindung wird eine Filteranordnung bereitgestellt. Die Filteranordnung umfasst einen Stromleiter, der einen gekrümmten (gebogenen oder geknickten) Verlauf aufweist und zum Durchleiten eines Stromes (bspw. eines Ausgangsstromes eines Spannungswandlers) eingerichtet ist. Die Filteranordnung umfasst ferner einen ersten Ferritkörper und einen zweiten Ferritkörper, die vorzugsweise jeweils einen gekrümmten Verlauf aufweisen und gemeinsam den Stromleiter (im Wesentlichen) umschließen. Dabei weisen der erste und der zweite Ferritkörper je eine Ausnehmung auf, die ebenfalls einen gekrümmten Verlauf aufweist und entlang der sich der Stromleiter erstreckt. Der Verlauf der Ferritkörper, insb. der Verlauf der Ausnehmung in diesen, entspricht dem Verlauf des Stromleiters.

Die gekrümmte Ausführung des Stromleiters ermöglicht eine flexible und dem zur Verfügung stehenden Bauraum angepasste Ausführung des Stromleiters sowie der beiden Ferritkörper und somit eine bauraumsparende Bauweise der Filteranordnung bei einer gleichbleibenden Gesamtinduktivität der Filteranordnung und somit bei einer gleichbleibenden Filterwirkung bzw. eine höhere Gesamtinduktivität und somit eine bessere Filterwirkung bei einem gleichbleibenden Bauraum der Filteranordnung.

Der erste und/oder der zweite Ferritkörper bilden jeweils eine von zwei Ferritkernhälften aus, die dank ihren gekrümmten Verläufen den Stromleiter trotz dessen gekrümmten Verlaufs gemeinsam umschließen können. Dies ermöglicht insb. eine sich über die gekrümmte Ausdehnung des Stromleiters erstreckende, durchgehende Umschließung des Stromleiters mit einem einzigen (aus zwei Ferritkernhälften bestehenden) Ferritkern, die im Vergleich zu einer abschnittweisen Umschließung des Stromleiters mit mehreren voneinander körperlich getrennten Ferritkernen eine insgesamt höhere Gesamtinduktivität bei der Filteranordnung und somit eine bessere Filterwirkung ermöglicht.

Hierbei bedeutet die Bezeichnung "gemeinsam umschließen", dass die beiden Ferritkörper gemeinsam einen und denselben (den Stromleiter umschließen) Ferritkern ausbilden und gemeinsam im Wesentlichen denselben Abschnitt des Stromleiters umschließen. Die Umschließung verläuft in Umfangsrichtung um den Stromleiter herum.

Die gekrümmten Verläufe der beiden Ferritkörper ermöglichen zudem, den gesamten, freiliegenden Bauraum in der Filteranordnung um den Stromleiter herum mit dem Ferritmaterial aufzufüllen, wodurch sich die von dem Magnetfeld durchflutende Querschnittfläche des Ferritkerns deutlich erhöht. Dadurch wird bei einem gleichbleibenden Bauraum in der Filteranordnung eine höhere Gesamtinduktivität bei der Filteranordnung erzielt. Zudem lässt sich das Sättigungsverhalten der Filteranordnung wesentlich besser bewältigen.

Damit ist eine Möglichkeit geschaffen, die Filteranordnung bei einer gleichbleibenden oder gar besseren Filterwirkung bauraumsparender zu bauen.

Mit der oben beschriebenen Filteranordnung kann somit eine hohe Gesamtinduktivität für hohe (zu filternde) Nutzströme realisiert werden. Derartige Filteranordnung kann daher insb. in elektrischen Systemen, wie z. B. in einem Bordnetz eines Hybridelektro- oder Elektrofahrzeugs, eingesetzt werden, wo hohe Leistungsdichten vorherrschen aber nur kleine Bauräume zur Verfügung stehen.

Die Ausnehmung und der Stromleiter sind vorzugsweise in deren jeweiligen Verläufen sowie in deren jeweiligen Querschnitten miteinander derart abgestimmt, dass der Stromleiter im Wesentlichen in einen durch die Ausnehmung ausgebildeten Hohlraum zwischen dem ersten und dem zweiten Ferritkörper passt.

Die Ausnehmung und der Stromleiter weisen vorzugsweise im Wesentlichen denselben gekrümmten Verlauf bzw. dieselbe gekrümmte Form auf, der bzw. die im Wesentlichen eine passgenaue Anordnung des Stromleiters in der Ausnehmung und eine passgenaue Umschließung des Stromleiters durch die beiden Ferritkörper ermöglicht.

Vorzugsweise ist die Ausnehmung im Wesentlichen nutförmig ausgebildet. Die Nut kann bspw. einen rechteckigen, trapezförmigen oder halbkreisförmigen Querschnitt haben.

Erfindungsgemäß weisen der erste und der zweite Ferritkörper zusammen (somit der Ferritkern) eine Mittellinie auf, die im Wesentlichen einer Mittellinie des Stromleiters entspricht, die sich in der Erstreckungsrichtung des Stromleiters erstreckt. Hierbei ist die Mittellinie der erste und der zweite Ferritkörper bzw. des Ferritkerns eine Ansammlung aller Schwerpunkte der Querschnitte der beiden Ferritkörper bzw. des diese beide Ferritkörper umfassenden Ferritkerns.

Insb. sind der erste und der zweite Ferritkörper um deren gemeinsame Mittellinie, die sich ebenfalls in der Erstreckungsrichtung des Stromleiters erstreckt, symmetrisch ausgebildet. Die Mittellinie entspricht insb. den Flächenschwerpunkten der Ferritkörper (gemeinsam).

Vorzugsweise weisen die beiden Ferritkörper und der Stromleiter denselben gekrümmten Verlauf bzw. dieselbe gekrümmte Form auf, der bzw. die entlang der länglichen Erstreckungsrichtung des Stromleiters symmetrische Querschnitte ermöglicht.

Vorzugsweise umfasst die Filteranordnung einen ersten und einen zweiten Stromanschluss, wobei der Stromleiter sich von dem ersten zu dem zweiten Stromanschluss erstreckt und den ersten und den zweiten Stromanschluss miteinander elektrisch verbindet.

Vorzugsweise erstrecken sich der erste und der zweite Ferritkörper ebenfalls im Wesentlichen von dem ersten zu dem zweiten Stromanschluss.

Vorzugsweise weist die Filteranordnung zwischen dem ersten und dem zweiten Ferritkörper zumindest einen Luftspalt auf, der im Wesentlichen sich in Erstreckungsrichtung des Stromleiters erstreckt. Vorzugsweise erstreckt sich der zumindest eine Luftspalt im Wesentlichen parallel zu der Mittellinie.

Durch den zumindest einen Luftspalt bildet sich ein offener Magnetkreis um den Stromleiter herum, wodurch wiederum das Sättigungsverhalten der beiden Ferritkörper (des Ferritkerns) bzw. der Filteranordnung abgeschwächt und somit verbessert wird. Durch entsprechende Änderung der Form und der Größe des zumindest einen Lustspaltes, wie z. B. der Spaltbreite, kann das Sättigungsverhalten bedarfsabhängig angepasst werden.

Vorzugsweise sind der erste Ferritkörper und/oder der zweite Ferritkörper jeweils einstückig ausgebildet.

Erfindungsgemäß weist der Stromleiter zumindest eine von der Mittellinie weg erstreckende Anformung auf, die ihrerseits ein freiliegendes Ende zur Herstellung eines elektrischen Kontaktes zu dem Stromleiter aufweist. Der erste und/oder der zweite Ferritkörper weisen zumindest eine weitere Ausnehmung auf, durch die die zumindest eine Anformung sich erstreckt.

Diese Anformungen können insb. als Stromabgriffe für Ableitkondensatoren dienen. Durch die Variierung in der Anzahl der Anformungen und Stellen an den beiden Ferritkörpern, wo diese Anformungen angeformt werden, kann eine Filteranordnung mit einstellbaren Teilinduktivitäten bereitgestellt werden, die entsprechend dem Anwendungsfall durch Bildung entsprechender elektrischer Kontakte zu den ausgewählten Anformungen angepasst werden können.

Gemäß einem weiteren Aspekt der Erfindung wird ein Spannungswandler bereitgestellt. Dabei umfasst der Spannungswandler eine Spannungswandlerschaltung zur Bereitstellung von Ausgangsströmen und eine zuvor beschriebene Filteranordnung zum Filtern der Ausgangsströme der Spannungswandlerschaltung, wobei der Stromleiter der Filteranordnung mit einem positiven Ausgangsanschluss der Spannungswandlerschaltung elektrisch leitend verbunden ist.

Vorteilhafte Ausgestaltungen der oben beschriebenen Filteranordnung sind, soweit im Übrigen auf den oben genannten Spannungswandler übertragbar, auch als vorteilhafte Ausgestaltungen des Spannungswandlers anzusehen.

Im Folgenden wird eine beispielhafte Ausführungsform der Erfindung bezugnehmend auf die beiliegende Zeichnung näher erläutert. Dabei zeigen:
- Figur 1: in einer schematischen Explosionsdarstellung einen Abschnitt einer Filteranordnung gemäß einer Ausführungsform der Erfindung;
- Figur 2: in einer schematischen Seitensichtdarstellung einen Abschnitt der in Figur 1 dargestellten Filteranordnung.

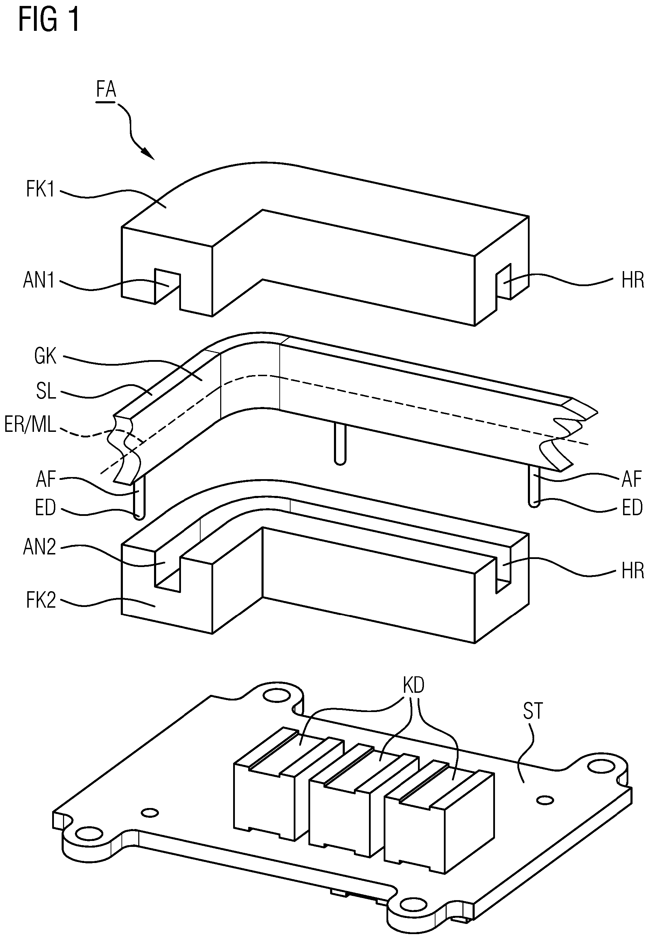

Figur 1 zeigt in einer schematischen Explosionsdarstellung einen Abschnitt einer Filteranordnung FA für einen in der Figur nicht dargestellten DC-DC-Wandler. Die Filteranordnung FA ist zwischen einem positiven Ausgangsanschluss einer in der Figur nicht dargestellten Spannungswandlerschaltung des DC-DC-Wandlers und einem Ausgangsanschluss des DC-DC-Wandlers elektrisch geschaltet und eingerichtet, Wechselspannungsanteile in den von der Spannungswandlerschaltung bereitgestellten Ausgangsströmen zu filtern und die gefilterten Ausgangsströme dem Ausgangsanschluss des DC-DC-Wandlers weiterzuleiten.

Die Filteranordnung FA umfasst einen Stromleiter SL (in der Figur ist nur ein Abschnitt des Stromleiters SL dargestellt), der eingerichtet ist, die Ausgangsströme der Spannungswandlerschaltung zu dem Ausgangsanschluss des DC-DC-Wandlers durchzuleiten und dabei die Wechselspannungsanteile in den Ausgangsströmen zu filtern.

Der Stromleiter SL umfasst einen Grundkörper GK, der im Wesentlichen aus einem gestanzten Streifen einer Kupferlegierung besteht und zur Reduzierung des Bauraumes der Filteranordnung L-förmig gekrümmt ausgeführt ist bzw. sich entlang einer L-förmigen Mittellinie ML erstreckt. Der Stromleiter SL umfasst ferner drei stabförmige Anformungen AF aus der gleichen Kupferlegierung, die sich seitlich von dem Grundkörper GK des Stromleiters SL und senkrecht zu der Mittellinie ML erstrecken. Die drei Anformungen AF sind beim Ausstanzen des Stromleiters SL mit gestanzt und somit mit dem Grundkörper GK einstückig ausgebildet. Die Anformungen AF dienen zur Herstellung elektrischer Kontakte von dem Stromleiter SL zu nachfolgend zu beschreibenden Ableitkondensatoren KD und weisen jeweils ein freiliegendes Ende ED zur Bildung der genannten elektrischen Kontakte auf.

Die Filteranordnung FA umfasst ferner einen ersten Ferritkörper FK1 und einen zweiten Ferritkörper FK2, wobei die beiden Ferritkörper FK1, FK2 zueinander im Wesentlichen um die Mittellinie ML des Stromleiters SL symmetrisch ausgebildet sind.

Die beiden Ferritkörper FK1, FK2 weisen auf jeweiligen dem Stromleiter SL zugewandten Oberflächen jeweils eine nutförmige Ausnehmung AN1, AN2 auf, die zueinander um die Mittellinie ML des Stromleiters SL symmetrisch ausgebildet sind.

Die Formen und Querschnitten des Stromleiters SL, der beiden Ausnehmungen AN1, AN2 sind miteinander derart abgestimmt, dass die beiden Ausnehmungen AN1, AN2 einen Hohlraum HR ausbilden, der den Stromleiter SL gerade in sich aufnehmen kann und den der Stromleiter SL auch gerade auffüllt. Die beiden Ferritkörper FK1, FK2 bilden somit gemeinsam einen einzigen Ferritkern aus, der den Stromleiter SL in dessen Erstreckungsrichtung ER nahezu vollständig umschließt.

Die Filteranordnung FA umfasst ferner einen Schaltungsträger ST zur mechanischen Befestigung des Stromleiters SL und der beiden Ferritkörper FK1, FK2.

Die Filteranordnung FA umfasst außerdem drei zuvor genannte Ableitkondensatoren KD, die auf dem Schaltungsträger ST angeordnet und mechanisch befestigt sind. Die drei Ableitkondensatoren KD sind jeweils mit einer der drei Anformungen AF elektrisch verbunden und bilden mit dem Stromleiter SL und den beiden Ferritkörpern FK1, FK2 einen Tiefpassfilter in einer π-Topologie aus.

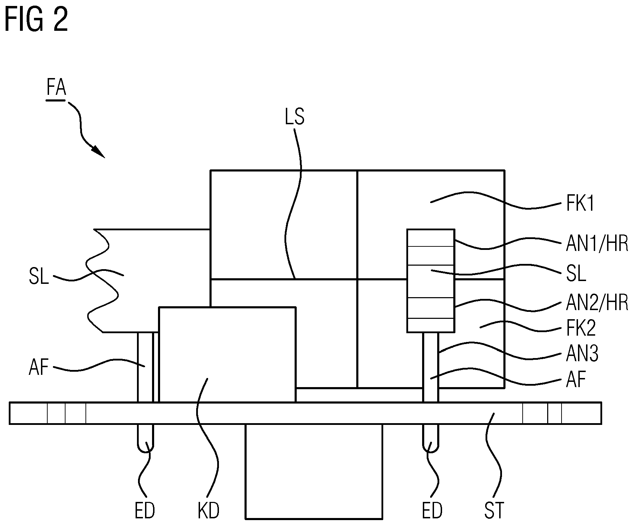

Figur 2 zeigt in einer schematischen Seitendarstellung die in Figur 1 dargestellten Filteranordnung FA (bzw. einen Abschnitt der Filteranordnung FA) in einem zusammengebauten Zustand.

Im zusammengebauten Zustand umschließen die beiden Ferritkörper FK1, FK2 den Stromleiter SL in dessen Umfangrichtung bis auf einen Luftspalt LS vollständig. Der Luftspalt LS erstreckt sich im Wesentlichen parallel zu der Mittellinie ML des Stromleiters SL. Der Luftspalt LS verbessert das Sättigungsverhalten der Filteranordnung FA und ermöglicht somit eine Filterung eines höheren Nutzstromes.

Die Anformungen AF an dem Stromleiter SL ragen dabei durch entsprechende Ausnehmungen AN3 an dem zweiten Ferritkörper FK2 aus dem Hohlraum HR hinaus und sind über die freiliegenden Enden ED an dem Schaltungsträger ST befestigt und mit Leiterbahnen auf dem Schaltungsträger ST elektrisch leitend verbunden, die zu den jeweiligen entsprechenden Ableitkondensatoren KD führen und mit entsprechenden Stromanschlüssen der Ableitkondensatoren KD elektrisch verbunden sind.

Die gekrümmten Formen des Stromleiters SL und der beiden Ferritkörper FK1, FK2 ermöglichen eine bauraumsparende Bauweise der Filteranordnung FA. Die form- und querschnittangepassten Ausführungen des Stromleiters SL und der beiden Ausnehmungen AN1, AN2 an den beiden Ferritkörpern FK1, FK2 ermöglichen eine Bildung eines einstückigen Ferritkerns, der den Stromleiter SL trotz dessen gekrümmten Form über die nahezu gesamte Erstreckung des Stromleiters SL vollständig umschließen kann. Dies ermöglicht eine höhere Gesamtinduktivität der Filteranordnung FA.

## Patentansprüche

1. Filteranordnung (FA), umfassend:
- einen Stromleiter (SL) mit gekrümmtem Verlauf zum Durchleiten eines Stromes;
- einen ersten Ferritkörper (FK1) und einen zweiten Ferritkörper (FK2);
- je eine Ausnehmung (AN1, AN2) in dem ersten (FK1) und dem zweiten (FK2) Ferritkörper mit gekrümmtem Verlauf;
- wobei der erste (FK1) und der zweite (FK2) Ferritkörper gemeinsam den Stromleiter (SL) umschließen, und
- der Stromleiter (SL) sich entlang der Ausnehmungen (AN1, AN2) erstreckt;
- wobei der erste (FK1) und der zweite (FK2) Ferritkörper zusammen eine Mittellinie aufweisen, die im Wesentlichen einer Mittellinie (ML) des Stromleiters (SL), die sich in der Erstreckungsrichtung (ER) des Stromleiters (SL) erstreckt, entspricht,
**dadurch gekennzeichnet, dass**
- der Stromleiter (SL) zumindest eine von der Mittellinie (ML) weg erstreckende Anformung (AF) mit einem freiliegenden Ende (ED) aufweist, und
- der erste (FK1) und/oder der zweite Ferritkörper (FK2) zumindest eine weitere Ausnehmung (AN3) aufweisen, durch die sich die zumindest eine Anformung (AF) erstreckt, wobei das freiliegende Ende (ED) einen elektrischen Kontakt zu dem Stromleiter (SL) ausbildet.

2. Filteranordnung (FA) nach Anspruch 1, wobei die Ausnehmung (AN1, AN2) und der Stromleiter (SL) in deren jeweiligen Verläufen sowie in deren jeweiligen Querschnitten miteinander derart abgestimmt sind, dass der Stromleiter (SL) in einen durch die Ausnehmung (AN1, AN2) des ersten (FK1) und/oder des zweiten (FK2) Ferritkörpers ausgebildeten Hohlraum (HR) zwischen dem ersten (FK1) und dem zweiten (FK2) Ferritkörper passt.

3. Filteranordnung (FA) nach einem der vorangehenden Ansprüche, umfassend einen Luftspalt (LS) zwischen dem ersten (FK1) und dem zweiten (FK2) Ferritkörper, der im Wesentlichen sich in Erstreckungsrichtung (ER) des Stromleiters (SL) erstreckt.

4. Filteranordnung (FA) nach Anspruch 3, wobei der eine Luftspalt (LS) sich im Wesentlichen parallel zu der Mittellinie (ML) erstreckt.

5. Filteranordnung (FA) nach einem der vorangehenden Ansprüche, wobei der erste Ferritkörper (FK1) und/oder der zweite Ferritkörper (FK2) jeweils einstückig ausgebildet sind.

6. Spannungswandler, insb. für einen Bordnetz eines Fahrzeugs, umfassend eine Spannungswandlerschaltung zur Bereitstellung von Ausgangsströmen und eine Filteranordnung (FA) nach einem der vorangehenden Ansprüche zum Filtern von den von der Spannungswandlerschaltung bereitgestellten Ausgangsströmen, wobei der Stromleiter (SL) der Filteranordnung (FA) mit einem Ausgang der Spannungswandlerschaltung elektrisch leitend verbunden ist.

## Claims

1. Filter assembly (FA) comprising:
- a current conductor (SL) with a curved profile for conducting a current;
- a first ferrite body (FK1) and a second ferrite body (FK2);
- a respective recess (AN1, AN2) in the first ferrite body (FK1) and the second ferrite body (FK2) with a curved profile;
- wherein the first ferrite body (FK1) and the second ferrite body (FK2) jointly surround the current conductor (SL), and
- the current conductor (SL) extends along the recesses (AN1, AN2);
- wherein the first ferrite body (FK1) and the second ferrite body (FK2) together have a centre line which corresponds substantially to a centre line (ML) of the current conductor (SL) which extends in the direction of extent (ER) of the current conductor (SL),
**characterized in that**
- the current conductor (SL) has at least one integrally formed portion (AF) which extends away from the centre line (ML) and has an exposed end (ED), and
- the first ferrite body (FK1) and/or the second ferrite body (FK2) have/has at least one further recess (AN3) through which the at least one integrally formed portion (AF) extends, wherein the exposed end (ED) forms an electrical contact to the current conductor (SL).

2. Filter assembly (FA) according to Claim 1, wherein the recess (AN1, AN2) and the current conductor (SL) are matched to one another in terms of their respective profiles and also in terms of their respective cross sections in such a way that the current conductor (SL) fits into a hollow space (HR), which is formed by the recess (AN1, AN2) of the first ferrite body (FK1) and/or of the second ferrite body (FK2), between the first ferrite body (FK1) and the second ferrite body (FK2).

3. Filter assembly (FA) according to either of the preceding claims, comprising an air gap (LS) between the first ferrite body (FK1) and the second ferrite body (FK2), which air gap extends substantially in the direction of extent (ER) of the current conductor (SL).

4. Filter assembly (FA) according to Claim 3, wherein the one air gap (LS) extends substantially parallel to the centre line (ML).

5. Filter assembly (FA) according to one of the preceding claims, wherein the first ferrite body (FK1) and/or the second ferrite body (FK2) are each integrally formed.

6. Voltage converter, in particular for an on-board electrical system of a vehicle, comprising a voltage converter circuit for providing output currents and a filter assembly (FA) according to one of the preceding claims for filtering the output currents which are provided by the voltage converter circuit, wherein the current conductor (SL) of the filter assembly (FA) is electrically conductively connected to an output of the voltage converter circuit.

## Revendications

1. Ensemble de filtrage (FA), comprenant :
- un conducteur de courant (SL) à tracé courbe pour faire passer un courant ;
- un premier corps de ferrite (FK1) et un deuxième corps de ferrite (FK2) ;
- respectivement un évidement (AN1, AN2) dans le premier (FK1) et le deuxième (FK2) corps de ferrite à tracé courbe ;
- dans lequel le premier (FK1) et le deuxième (FK2) corps de ferrite entourent conjointement le conducteur de courant (SL), et
- le conducteur de courant (SL) s'étend le long des évidements (AN1, AN2) ;
- le premier (FK1) et le deuxième (FK2) corps de ferrite présentant ensemble une ligne médiane qui correspond substantiellement à une ligne médiane (ML) du conducteur de courant (SL) qui s'étend dans la direction d'extension (ER) du conducteur de courant (SL),
**caractérisé en ce que**
- le conducteur de courant (SL) présente au moins un surmoulage (AF) s'éloignant de la ligne médiane (ML) et ayant une extrémité exposée (ED), et
- le premier (FK1) et/ou le deuxième corps de ferrite (FK2) présentent au moins un autre évidement (AN3) à travers lequel s'étend ledit au moins un surmoulage (AF), l'extrémité exposée (ED) réalisant un contact électrique avec le conducteur de courant (SL).

2. Ensemble de filtrage (FA) selon la revendication 1, dans lequel l'évidement (AN1, AN2) et le conducteur de courant (SL) sont adaptés l'un par rapport à l'autre au niveau de leurs tracés respectifs ainsi que de leurs sections transversales respectives de telle sorte que le conducteur de courant (SL) entre dans une cavité (HR) réalisée par les évidements (AN1, AN2) du premier (FK1) et/ou du deuxième (FK2) corps de ferrite, entre le premier (FK1) et le deuxième (FK2) corps de ferrite.

3. Ensemble de filtrage (FA) selon l'une quelconque des revendications précédentes, comprenant un entrefer (LS) entre le premier (FK1) et le deuxième (FK2) corps de ferrite qui s'étend substantiellement dans la direction d'extension (ER) du conducteur de courant (SL) .

4. Ensemble de filtrage (FA) selon la revendication 3, dans lequel ledit entrefer (LS) s'étend de manière substantiellement parallèle à la ligne médiane (ML).

5. Ensemble de filtrage (FA) selon l'une quelconque des revendications précédentes, dans lequel le premier corps de ferrite (FK1) et/ou le deuxième corps de ferrite (FK2) sont respectivement réalisés d'un seul tenant.

6. Transformateur de tension, en particulier pour un réseau de bord d'un véhicule, comprenant un circuit de transformateur de tension pour fournir des courants de sortie et un ensemble de filtrage (FA) selon l'une quelconque des revendications précédentes pour filtrer les courants de sortie fournis par le circuit de transformateur de tension, le conducteur de courant (SL) de l'ensemble de filtrage (FA) étant relié de manière électriquement conductrice à une sortie du circuit de transformateur de tension.
